Europäisches Patentamt

European Patent Office

Office européen des brevets

(11) Publication number: **0 161 088**
**B1**

# (12) EUROPEAN PATENT SPECIFICATION

(45) Date of publication of patent specification: **08.06.88**

(21) Application number: **85302864.5**

(22) Date of filing: **24.04.85**

(51) Int. Cl.⁴: **C 23 C 14/08,** C 23 C 14/30, C 23 C 14/40, H 01 L 21/203, H 01 L 31/18

(54) Apparatus for plasma-assisted deposition of thin films.

(30) Priority: **02.05.84 US 606014**

(43) Date of publication of application:
**13.11.85 Bulletin 85/46**

(45) Publication of the grant of the patent:
**08.06.88 Bulletin 88/23**

(84) Designated Contracting States:
**CH DE FR GB IT LI NL**

(56) References cited:
EP-A-0 060 651
EP-A-0 076 426
EP-A-0 104 916
EP-A-0 112 132

THIN SOLID FILMS, vol. 107, 1983 R.F. BUNSHAH: "Process of the activated reactive evaporation type and their tribological applications" pages 21-38

(73) Proprietor: **ENERGY CONVERSION DEVICES, INC.**
**1675 West Maple Road**
**Troy Michigan 48084 (US)**

(72) Inventor: **Nath, Prem.**
**245 Prospect**
**Rochester Michigan 48063 (US)**

(74) Representative: **Jackson, Peter Arthur et al**
**GILL JENNINGS & EVERY 53-64 Chancery Lane**
**London WC2A 1HN (GB)**

(56) References cited:
**PATENT ABSTRACTS OF JAPAN, unexamined applications, C. field, vol. 8, no. 98, May 9, 1984 THE PATENT OFFICE JAPANESE GOVERNMENT page 69 C 221**

## Description

The present invention concerns a plasma-assisted, electron beam evaporation apparatus for depositing films, particularly electrically conductive, light transmitting films. Such films may be deposited by simple vacuum evaporation, but it is difficult to control the composition of such deposited films when they contain a number of constituents, such as indium tin oxide films. In reactive evaporation, a residual atmosphere chemically reacts with other film constituents to produce the film compound. For example, oxygen may react with vaporized tin and indium for depositing an indium tin oxide film. However, since such reactions are generally very slow, film deposition rates are undesirably low.

The rate of a reactive evaporation process may be accelerated by an activated evaporation process such as is disclosed in U.S. Patent No. 4,336,277 and "Preparation of $In_2O_3$ and Tin-doped $In_2O_3$ Films by a Novel Activated Reactive Evaporation Technique", *Thin Solid Films*, (1980), both by Bunshah and Nath. These references disclose resistive heating of indium and tin metals in the presence of an electron flux to produce a plasma. The process is performed at a pressure about $13 \times 10^{-3}$ pascal in the presence of argon and a magnetic field.

EP—A—112 132 to Nath discloses use of radio frequency energy to ionize evaporated solids, such as tin or indium, to promote their reaction with oxygen.

It is also known that solid deposition sources may be heated by electron beam bombardment. Secondary electrons produced in this process may be used to ionize the evaporated material. See, Bunshah, "Processes of the Activated Reactive Evaporation Type and Their Tribological Applications" 107, *Thin Solid Films,* page 26 (1983).

U.S. Patent No. 4,361,114 discloses radio frequency ionization of oxygen in vapour deposition of indium tin oxide. The oxygen ionization occurs at a point remote and isolated from the tin and indium vapours.

None of these processes produces sufficient deposition rates or rates that are independent of the evaporation rate or temperature of the solid source materials.

EP—A—0104916 discloses apparatus for depositing a thin film composed of at least two elements on a substrate, the apparatus comprising a vacuum chamber; a crucible disposed in the chamber for receiving a solid material containing at least one element to be incorporated in a deposited film; an electron beam source disposed in the chamber for generating an electron beam to heat and evaporate a solid source disposed in the crucible; a gas inlet in the chamber for admitting a gas containing at least one element to be incorporated in the deposited films, the gas inlet being disposed proximate the crucible; and an electrode disposed in the chamber proximate the crucible and the gas inlet for establishing a plasma for ionizing the evaporated source and the gas. According to the present invention, such apparatus is characterized in that the electrode comprises three spaced-apart, generally parallel plates having aligned central apertures; and in that the intermediate plate is electrically isolated from the other plates and the other plates are electrically connected to each other. This electrode construction serves to confine the plasma and limit ionic bombardment of the substrate.

Preferably, the plates are spaced at a distance less than the dark space of the plasma. The aligned central apertures that may be of different diameters or may be covered with a screen to confine the plasma.

In the accompanying drawings:—

Figure 1 is a fragmentary, cross-sectional view of a stacked photovoltaic device comprising a plurality of p-i-n type cells, each layer of the cells formed from an amorphous semiconductor alloy, the device including a transparent thin film conductive oxide electrode layer;

Figure 2 is a cross-sectional view illustrating apparatus for depositing the thin film electrode of Figure 1 onto a continuously moving substrate;

Figure 3A is a fragmentary, cross-sectional, perspective view of a preferred electrode assembly for use in the apparatus; and

Figure 3B is a fragmentary, cross-sectional, perspective view of another electrode assembly, similar to the assembly of Figure 3A.

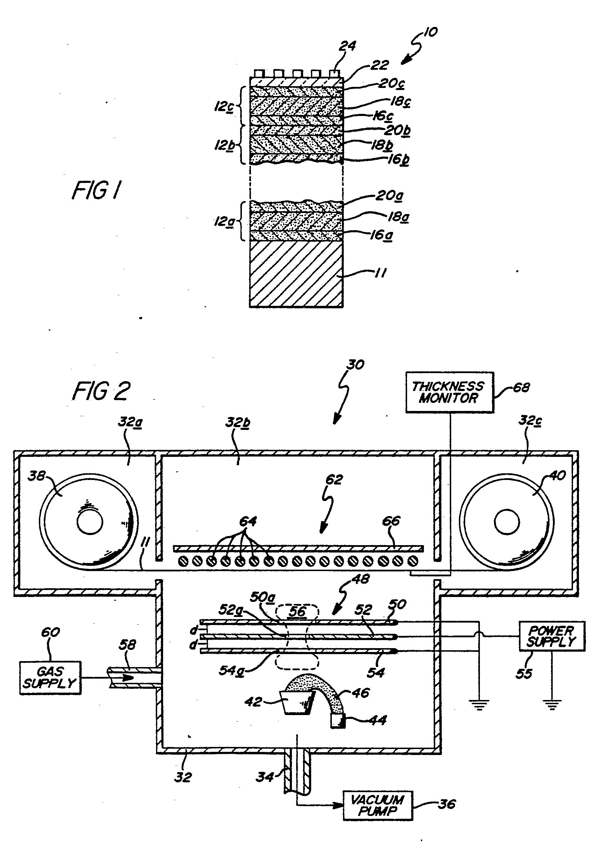

Figure 1 shows a p-i-n type photovoltaic device 10, such as a solar cell, made up of individual p-i-n type cells 12a, 12b and 12c. A substrate 11 forms a surface of cell 10 and functions as the first electrode. Substrate 11 may be transparent or formed from a metallic material such as stainless steel, aluminum, tantalum, molybdenum or chromium, with or without an insulating layer thereon, or may be an insulating material such as glass with or without embedded metallic particles. Certain applications may require the deposition of a thin conductive oxide layer and/or a thin, resistive barrier layer, and/or a series of base contacts prior to deposition of the semiconductor material. The term "substrate" includes not only a flexible film, but also any elements added to it by preliminary processing.

Each of cells 12a, 12b and 12c is preferably fabricated with an amorphous semiconductor body containing at least a silicon or germanium alloy. Each of the semiconductor bodies includes a n-type conductivity semiconductor layer 20a, 20b and 20c; an intrinsic semiconductor layer 18a, 18b and 18c; and a p-type conductivity semiconductor layer 16a, 16b and 16c. As illustrated, cell 12b is an intermediate cell and additional intermediate cells may be stacked on the illustrated cells.

A transparent conductive oxide (TCO) layer 22, formed in the preferred embodiment of indium tin oxide, forms a second electrode on device 10. A metallic electrode grid 24 may be applied to layer 22 to shorten the carrier path through the TCO and increase current collection efficiency.

While cell 10 is a stacked assembly of p-i-n type photovoltaic cells, the invention may be used in the fabrication of other electronic devices such as single p-i-n cells, stacked or single n-i-p cells, p-n cells, Schottky barrier cells, transistors, diodes, integrated circuits, photodetectors, and other semiconductor devices, as well as any other application requiring the deposition of a thin film of material, such as the manufacture of interference filters, the preparation of optical coatings, etc.

In Figure 2, a preferred embodiment of an apparatus 30 for depositing films according to the invention is shown in cross section. A vacuum chamber 32 is evacuated through a conduit 34 by a vacuum pump 36. Vacuum chamber 32 is divided into three communicating regions: the substrate supply region 32a; the deposition region 32b; and the substrate take-up region 32c. Substrate supply region 32a houses a supply roll 38 of web substrate 11 and substrate take-up roller 40 about which wet substrate 11 may be wound. Web substrate material 11 extends from substrate supply reel 38 through deposition region 32b and to take-up roller 40. Motors (not illustrated) continuously advance the web substrate 11 through deposition region 32b.

A solid precursor material is disposed in a crucible 42. An electron beam source 44 provides a beam 46 focused by a conventional magnetic field to impinge upon the precursor material in crucible 42. Electron beam 46 is attracted to crucible 42 by maintaining a positive potential on the crucible. By controlling the beam current and voltage, the rate of evaporation of the solid precursor material from crucible 42 may be controlled. Precursor materials disposed in a single crucible may be vaporized by multiple electron beams; or, multiple crucibles and multiple electron beams may be employed to evaporate precursor materials having different melting points. Or a single electron beam may be rapidly switched between several crucibles to vaporize precursor material in each of them.

An electrode assembly 48 disposed between substrate 11 and crucible 42 is used to transmit electromagnetic energy to the precursor material vaporized from crucible 42 and to the reactant gas introduced into chamber 32b. Electrode assembly 48 comprises three planar, generally parallel electrically conductive plates 50, 52 and 54 spaced from one another by a distance "d". Each of conductive plates 50, 52 and 54 includes a central opening 50a, 52a and 54a, respectively. In apparatus 30, plates 50, 52 and 54 are generally horizontal. Outer plates 50 and 54 are electrically grounded, while central plate 52 is energized by a radio frequency power supply 55, operating at a conventional frequency, e.g., 13.56 MHz, or at a microwave frequency.

Electrode assembly 48 restricts the activating plasma to a relatively small region 56 (indicated in Figure 2 in phantom outline) proximate the central openings 50a, 52a and 54a in the conductive plates, 50, 52 and 54, to limit ionic bombardment of substrate 11. The distance separating each of the conductive plates is chosen to be less than the cathode dark space distance of the central plate 52 at the operating conditions to prevent formation of a plasma between the planar surfaces of the contiguous plates. Central opening 52a in the central plate 52 is slightly smaller than openings 50a and 54a in the contiguous grounded plates 50 and 54. This geometrical arrangement also helps confine the plasma.

Apparatus 30 includes a reactant gas inlet 58 in communication with a gas supply source 60 and deposition region 32b directing reactant gas towards plasma region 56. Gaseous reactant materials, such as oxygen, nitrogen, hydrogen, ammonia, hydrogen sulfide, nitrous oxide, carbon tetrafluoride etc., may be introduced into evaporation apparatus 30 for activation by electrode assembly 48 and combination with precursor material evaporated from crucible 42 to produce a compound. The compound is deposited on substrate 11. Apparatus 30 may preferably include a substrate heater 62, such as a plurality of radiant heating lamps 64 and an associated radiant heat reflector 66 for heating substrate 11. A thickness monitor 68, such as an optical or piezoelectric monitoring device, may be used to measure the thickness of the thin film deposited on web substrate 11.

As an example of the materials that can be deposited by apparatus 30, a thin film of indium tin oxide may be deposited on a body of amorphous silicon semiconductor material that has been deposited on a web of stainless steel substrate material 11. In this example, web substrate material 11 is threaded through deposition apparatus 30 from supply roll 38 through deposition region 32b and to take-up roll 40. A solid metallic precursor material comprising 85 atomic percent indium and 15 atomic percent tin is disposed in crucible 42. Apparatus 30 is evacuated to a pressure of about $1.33 \times 10^{-3}$ pascal and backfilled through inlet 58 with oxygen, the reactant gas, to a pressure of about .13 pascal. A power of about 100 watts at a frequency of 13.56 MHz is delivered to cathode plate 52 to form an ionized oxygen plasma in region 56. Heater assembly 62 heats substrate 11 in chamber 32b to approximately 150°C to 300°C. Electron beam source 44 bombards the material in crucible 42 and evaporates the indium tin precursor material. The indium and tin vapors diffuse into region 56 where they are activated by the plasma and react with the oxygen gas to produce the desired indium tin oxide compound that is deposited on continuously advancing web 11. Indium tin oxide deposited in this manner to a thickness of about 60 nanometers exhibits a sheet resistance of about 30—40 ohms per square, and a light transmission (integrated avarage percent from about 400 to 800 nanometers) of greater than 90 per cent when deposited on glass.

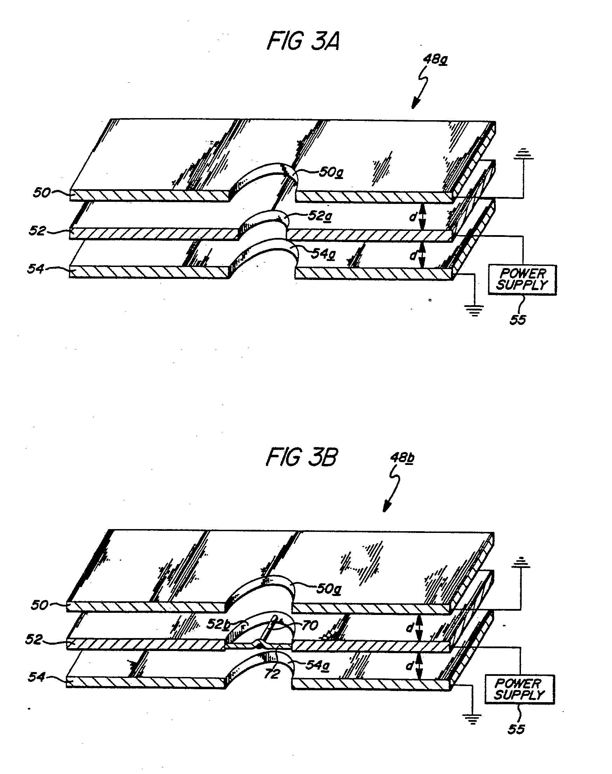

In Figure 3A an electrode assembly 48a, similar to that depicted in Figure 2, includes three generally planar, parallel plates 50, 52, 54, formed of an electrically conductive material such as aluminum or stainless steel. Each of the conductive plate includes a central generally circular aperture 50a, 52a and 54a, respectively.

Plates 50, 52 and 54 are spaced from one another by a distance d which is less than the dark space distance for an electrode opeating at a particular frequency and in a particular pressure. Dark Space means that region of a glow discharge immediately adjacent the electrode in which little or no plasma discharge or light is produced. Aperture 52a in plate 32 is of a smaller diameter than are the apertures 50a and 54a. By making aperture 52a somewhat smaller than those in the grounded plates 50 and 54, a plasma may be formed in the region extending through the apertures.

Electrode assembly 48b in Figure 3B is similar to electrode assembly 48a, except apertures 50a, 52b and 54a in conductive plates 50, 52 and 54 are all of approximately the same diameter. However, a pair of crossed, substantially perpendicular, electrically conductive wires 70 and 72 extend across the aperture 52b. Crossed conductive wires 70 and 72 function to confine the plasma in substantially the same manner as the small central aperture in the plate 52 of assembly 48a. Similarly an electrically conductive wire grid or wire mesh could extend across the aperture of the central conductive plate 52. Other aperture configurations may be employed to confine the plasma region to the immediate vicinity of the apertures. For example, central conductive plate 52 may have a star-shaped aperture. In that configuration, the inward projecting portions of the aperture confine and sustain the plasma.

**Claims**

1. Apparatus for depositing a thin film composed of at least two elements on a substrate, the apparatus comprising a vacuum chamber (32b); a crucible (42) disposed in the chamber (32b) for receiving a solid material containing at least one element to be incorporated in a deposited film; an electron beam source (44) disposed in the chamber for generating an electron beam to heat and evaporate a solid source disposed in the crucible (42); a gas inlet (58) in the chamber for admitting a gas containing at least one element to be incorporated in the deposited film, the gas inlet (58) being disposed proximate the crucible (42); and an electrode (48) disposed in the chamber proximate the crucible (42) and the gas inlet (58) for establishing a plasma for ionizing the evaporated source and the gas; characterized in that the electrode (48) comprises three spaced-apart, generally parallel plates (50, 52, 54) having aligned central apertures (50a, 52a, 54a); and in that the intermediate plate is electrically isolated from the other plates and the other plates are electrically connected to each other.

2. Apparatus according to claim 1, wherein the aperture (52a) in the intermediate plate (52) is smaller in area than the apertures (50a, 54a) in the other plates (50, 54).

3. Apparatus according to claim 1, wherein a thin electrically conductive member (70) is disposed across the aperture (52b) and the intermediate plate (52).

4. Apparatus according to any one of the preceding claims wherein a source (55) of radio frequency energy is electrically connected to the intermediate plate (52) and the other plates (50, 54) are electrically grounded.

5. Apparatus according to any one of the preceding claims, wherein a heater (64) is disposed in the chamber (32b) for heating the substrate (11).

6. Apparatus according to any one of the preceding claims, wherein the apparatus includes motor driven coils (38, 40) for continuously moving the substrate (11) in the form of a continuous web through the chamber (32b).

**Patentansprüche**

1. Vorrichtung zur Ausfällung eines dünnen Films aus mindestens zwei Elementen auf einem Substrat, wobei die Vorrichtung eine Vakuumkammer (32b); einen Tiegel (42) in der Kammer (32b) zur Aufnahme eines Feststoffes, der mindestens eines der im Film anwesenden Elemente enthält, eine Elektronenstrahlenquelle (44) innerhalb der Kammer zur Erzeugung eines Elektronenstrahls zum Erhitzen und zur Vedampfung eines im Tiegel (42) vorgesehenen Feststoffes, einem Gaseinlaßrohr (58) in die Kammer, um ein Gas zuzuführen, das mindestens eines der in dem auszufällenden Film vorgesehenen Element enthält, wobei das Gaseinlaßrohr (58) zum Tiegel (42) benachbart angeordnet ist; und einer Elektrode (49), die in der Kammer benachbart zum Tiegel (42) und zum Gaszuführungsrohr (58) angeordnet ist und zur Erzeugung eines Plasma zur Ioniserung der verdampften Quelle und des Gases, dadurch gekennzeichnet, daß die Elektrode (48) drei voneinander im Abstand angeordnete, im allgemeinen parallele Platten (50, 52, 54) in Reihe mit zentralen Öffnungen (50a, 52a, 54a) aufweist und.die mittlere Platte elektrisch von den anderen Platten isoliert vorgesehen ist und die anderen Platten untereinander elektrisch in Verbindung miteinander stehen.

2. Vorrichtung gemäß Anspruch 1, dadurch gekennzeichnet, daß die Öffnung (52a) in der mittleren Platte (52) kleiner im Bereich als die Öffnungen (50a, 54a) in den anderen Platten (50, 54) sind.

3. Vorrichtung gemäß Anspruch 1, dadurch gekennzeichnet, daß ein dünnes elektrisches Leitelement (70) über die Öffnung (52b) in der mittleren Platte (52) vorgesehen ist.

4. Vorrichtung gemäß irgendeinem der vorstehenden Ansprüche, dadurch gekennzeichnet, daß eine Quelle (55) für Radiofrequenzenergie elektrisch mit der mittleren Platte (52) verbunden ist und die anderen Platten (50, 54) elektrisch geerdet sind.

5. Vorrichtung gemäß irgendeinem der vorstehenden Ansprüche, dadurch gekennzeichnet, daß eine Heizvorrichtung (64) in der Kammer (32b) zum Erhitzen des Substrats (11) vorgesehen ist.

6. Vorrichtung gemäß irgendeinem der vorstehenden Ansprüche, dadurch gekennzeichnet, daß in der Vorrichtung motorgetriebene Rollen (38, 40) vorgeshen sind, um das Substrat (11) Kontinuierlich in Form eines kontinuierlichen Bandes durch die Kammer (32b) zu transportieren.

## Revendications

1. Appareil permettant de déposer sur un substrat un film mince composé d'au moins deux éléments, cet appareil comprenant une chambre à vide (32b), un creuset (42) disposé dans cette chambre (32b) pour recevoir un matériau solide contenant au moins un élément à incorporer dans le film à déposer, une source de faisceau d'électrons (44) disposée dans la chambre de façon à produire un faisceau d'électrons destiné à chauffer et vaporiser une source solide disposée dans le creuset (42), une entrée de gaz (58) disposés dans la chambre afin de permettre l'admission d'un gaz contenant au moins un élément à incorporer dans le film déposé, cette entrée de gaz (58) étant située à proximité du creuset (42), et une électrode (48) disposée dans la chambre à proximité du creuset (42) et de l'entrée de gaz (58) de façon à permettre l'établissement d'un plasma en vue de réaliser l'ionisation de la source vaporisée et du gaz, caractérisé en ce que l'électrode (48) comprend trois plaques espacées et sensiblement parallèles (50, 52, 54) comportant des ouvertures centrales alignées (50a, 52a, 54a) et en ce que la plaque intermédiaire est isolée électriquement des autres plaques et ces autres plaques sont reliées électriquement l'une à l'autre.

2. Appareil selon la revendication 1, dans lequel l'ouverture (52a) de la plaque intermédiaire (52) a une aire plus petite que les ouvertures (50a, 54a) des autres plaques (50, 54).

3. Appareil selon la revendication 1, dans lequel une pièce mince électriquement conductrice (70) est disposée en travers de l'ouverture (52b) de la plaque intermédiaire (52).

4. Appareil selon l'une quelconque des revendications précédentes, dans lequel une source (55) d'énergie haute fréquence est reliée électriquement à la plaque intermédiaire (52) et les autres plaques (50, 54) sont mises à la masse sur le plan électrique.

5. Appareil selon l'une quelconque des revendications précédentes, dans lequel un dispositif de chauffage (64) est disposé dans la chambre (32b) afin de permettre un chauffage du substrat (11).

6. Appareil selon l'une quelconque des revendications précédentes, dans lequel cet appareil comprend des bobines (38, 44) entraînées par un moteur et permettant de déplacer la substrat (11) d'une manière continue à travers la chambre (32b), sous la forme d'une nappe continue.

FIG 1

FIG 2

THICKNESS MONITOR — 68

GAS SUPPLY — 60

POWER SUPPLY — 55

VACUUM PUMP — 36

FIG 3A

48a

50

50a

52

52a

d

54

54a

d

POWER
SUPPLY

55

FIG 3B

48b

50

50a

52

52b

70

d'

54

72

54a

d'

POWER
SUPPLY

55